# EUROPEAN PATENT SPECIFICATION

(11) **EP 4 372 552 B1**
(45) Date of publication and mention of the grant of the patent: **31.12.2025**
(21) Application number: 22207780.2
(22) Date of filing: 16.11.2022
(51) Int. Cl.: G06F 9/4401, G06F 1/30, G06F 1/26, H02H 3/05, G06F 11/30, G06F 8/65, H02H 5/04, H02H 9/02, G01R 19/25, G01R 19/165, G06F 9/455, G01R 21/133, H02H 1/00, H02H 3/08

(54) **QUICK START FOR IEDS**
SCHNELLSTART FÜR IEDS
DÉMARRAGE RAPIDE D'IEDS

(43) Date of publication of application: 22.05.2024
(73) Proprietor: Hitachi Energy Ltd, 8050 Zürich (CH)
(72) Inventor: DAN, Andrei-Marian, 8112 Otelfingen (CH); DECK, Bernhard, 79809 Weilheim (DE); EIDENBENZ, Raphael, 8049 Zürich (CH); SIPOWICZ, Jakub, 30-348 Kraków (PL)
(74) Representative: Vossius & Partner Patentanwälte Rechtsanwälte mbB

(56) References cited:
- US-A1- 2013 013 909
- US-A1- 2017 185 770
- US-A1- 2021 111 555
- US-A1- 2021 359 508

## Description

### TECHNICAL FIELD

The present disclosure in general relates to intelligent electronic devices (IEDs) and in particular to a method for controlling an intelligent electronic device for power system components, an IED for power system components and a corresponding system.

### BACKGROUND

IEDs are restarted during firmware updates, for loading new configurations, or in the presence of power supply failures. The reboot process can last for several minutes, given the growing complexity of the software stack (operating systems, applications, etc.). During this time, the functionality of the IED is not available. This can lead to important damage of the power system components. Due to the increased complexity and security requirements, restarts caused by firmware updates might become more frequent in the future, because the IEDs will receive new security patches more often. Also, with more software running on the IEDs, it will be increasingly necessary to update the software to fix bugs or add new functionality. These updates will likely require restarts of the device.

To eliminate the restarts caused by power supply failures, uninterruptible power supplies are often used in high voltage applications. However, these supplies represent additional system complexity, system costs, as well as additional maintenance and support requirements. This can represent a barrier to adoption in use-cases that require low-cost solutions. Another solution to mitigate the failure of an individual IED during restart is to use redundant devices, providing the same functionality. However, this method still suffers from the problem of the boot time interval when the system is not protected, in the case of a power supply failure. The present disclosure has thus been made in view of the above problems and challenges and provides increased protection of the power system component(s) and the grid attached to the lED.

US 2017/185770 A1, describes a system for protecting a computerized device by monitoring power consumption during the bootstrap process. It involves a DC supply monitoring unit that compares power consumption patterns against stored valid signatures to detect anomalies, indicating potential malicious activities.

US 2013/013909 A1, outlines a method and apparatus for ensuring a processor operates within safe parameters during boot-up. It includes logic circuitry to monitor and compare current operating points with stored safe ranges, ensuring secure boot processes by preventing operation outside tested limits.

US 2021/111555 A1 presents a system for providing primary and secondary protection in electric power delivery systems using primary protection relays and an integrator. The relays perform primary protection independently, while the integrator handles secondary applications like backup protection and system automation.
and US 2021/359508 A1 discusses systems and methods for isolating protective functions in electrical power systems to enhance reliability and security. It involves using separate processors and memory sections for protective and non-protective functions, ensuring that protection operations remain unaffected by faults in other system parts.

The invention is defined in the independent claims. Dependent claims describe preferred embodiments.

The present disclosure relates to a method for controlling an intelligent electronic device, IED, for power system components, the method comprising rebooting the IED, wherein rebooting comprises reloading an operating system, executing, while the IED is rebooting, a basic mode of the IED, wherein the basic mode comprises at least one function for protecting a power system component connected to the IED and executing a normal mode, after the operating system is reloaded, wherein the normal mode comprises functions for protecting and controlling the power system component.

The method further comprises performing a handover procedure, after the operating system is reloaded, to transfer the functions of the basic mode to the normal mode, wherein the execution of the basic mode is preferably stopped after performing the handover procedure.

Various embodiments may preferably implement the following features.

Preferably, the power system component is at least one of a circuit breaker, a transformer, a switch/load-break switch, a tap changer, an electric motor, or a capacitor.

The basic mode comprises monitoring a physical value of the system component.

The physical value is at least one of a current, a voltage, a pressure, a temperature, a power, a resistance, or an impedance.

Preferably, the method further comprises triggering a circuit breaker to take the IED off the grid in case the physical value exceeds a predetermined threshold preferably for a predetermined time.

The method is performed on two entities of the IED. The entities may be implemented as software and/or hardware.

The method comprises executing the basic mode on a first entity and the normal mode on a second entity.

Preferably, the first and second entities are provided as a single unit, or wherein the first entity is provided as a separate unit from the second entity.

Preferably, the first entity is a first processing unit and the second entity is a second processing unit.

Preferably, the first entity is a hypervisor and the second entity is a virtual machine.

The present disclosure further relates to an intelligent electronic device, IED, for power system components, the IED comprising a processing unit configured to reboot the IED, wherein rebooting comprises reloading an operating system, execute, while the IED is rebooting, a basic mode of the IED, wherein the processing unit is configured to provide at least one function for protecting a power system component connected to the IED in the basic mode, execute a normal mode, after the operating system is reloaded, wherein the processing unit is configured to provide functions for protecting and controlling the power system component in the normal mode.

The processing unit is further configured to perform a handover procedure, after the operating system is reloaded, to transfer the functions of the basic mode to the normal mode, wherein the processing unit is preferably further configured to stop the execution of the basic mode after performing the handover procedure.

Preferably, the IED is configured to be connected to a power system component, wherein the power system component is at least one of a circuit breaker, a transformer, a switch/load-break switch, a tap changer, an electric motor, or a capacitor.

The processing unit is further configured to, in the basic mode, monitor a physical value of the system component.

The physical value is at least one of a current, a voltage, a pressure, a temperature, a power, a resistance, or an impedance.

Preferably, the processing unit is further configured to trigger a circuit breaker in case the physical value exceeds a predetermined threshold preferably for a predetermined time.

The processing unit comprises two entities. The entities may be implemented as software and/or hardware.

A first entity is configured to execute the basic mode and a second entity is configured to execute the normal mode.

Preferably, the first and the second entity are provided as a single unit, or wherein the first entity is provided as a separate unit from the second entity.

Preferably, the processing unit is a system on chip, SoC, device, wherein the SoC device comprises at least one of a central processing unit, CPU, a digital signal processor, DSP, an image processing unit, or a graphics processing unit, GPU, and the first entity is configured to execute the basic mode on a subset of the SoC. This corresponds to an example of a hardware-based implementation.

Preferably, the first entity is a hypervisor configured to execute the basic mode and the second entity is a virtual machine configured to execute the normal mode. This corresponds to an example of a software-based implementation.

The present disclosure further relates to a system comprising a power system component and an intelligent electronic device, IED, as described above.

The exemplary embodiments disclosed herein are directed to providing features that will become readily apparent by reference to the following description when taken in conjunction with the accompany drawings. In accordance with various embodiments, exemplary systems, methods, devices and computer program products are disclosed herein. It is understood, however, that these embodiments are presented by way of example and not limitation, and it will be apparent to those of ordinary skill in the art who read the present disclosure that various modifications to the disclosed embodiments can be made while remaining within the scope of the claims.

The above and other aspects and their implementations are described in greater detail in the drawings, the descriptions, and the claims.

Fig. 1 shows a flowchart of an exemplary method according to the present disclosure.

Fig. 2 shows a schematic diagram of an exemplary IED according to the present disclosure.

The method according to the disclosure, which may also be referred to as a quick start of an IED, enables the IED to start basic control and/or protection functionality (basic mode) without waiting for the entire operating system to be reloaded, in the case of a reboot. In an embodiment, the basic IED mode may be executed outside of the operating system, until the system is completely reloaded.

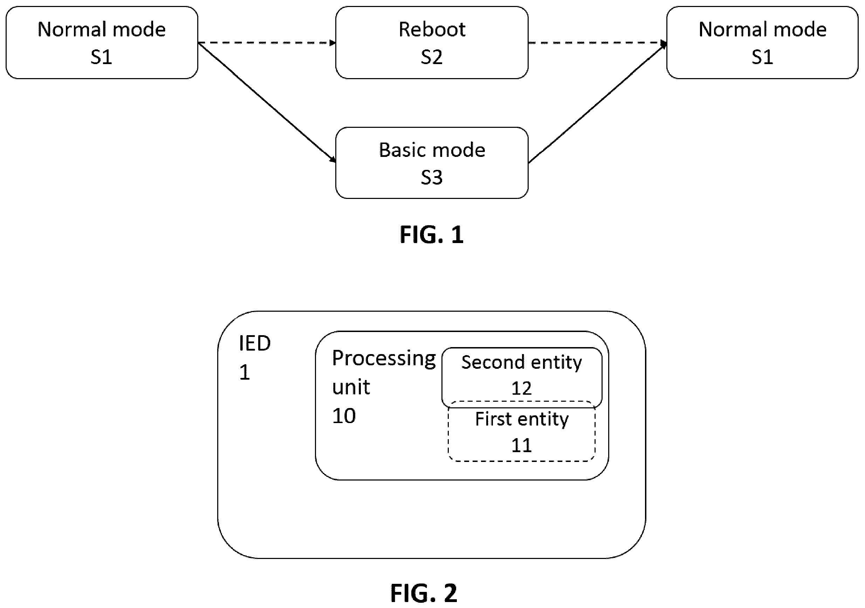

The method is described with reference to Fig. 1 showing an exemplary flow chart. The method is used for controlling an IED for power system components. In particular, when the IED is running in the normal mode S1, the method comprises rebooting S2 the IED, wherein the rebooting step S2 comprises reloading an operating system. In parallel to the rebooting step S2, the IED executes a basic mode S3 of the IED, wherein the basic mode comprises at least one function for protecting a power system component which is connected to the IED. After the operating system is reloaded, the IED executes the normal mode S1.

In other words, the IED performs a handover from executing the basic mode S3 (back) to executing the normal mode S1 after the operating system is reloaded and the rebooting step S2 is finished.

The power system component to which the IED is attached may be one of a circuit breaker, a transformer, a switch/load-break switch, a tap changer, an electric motor, or a capacitor. The above list is non-exhaustive and the present disclosure may also be employed for other suitable components.

In general, and as mentioned above, the basic mode may rather relate to functions concerning the protection of the attached system component while the normal mode in addition or alternatively may relate to functions concerning controlling the power system component.

The basic mode comprises monitoring a physical value of the system component. The physical value is at least one of a current, a voltage, a pressure, a temperature, a power, a resistance, or an impedance.

The method may further comprise triggering a circuit breaker in case the physical value exceeds a predetermined threshold. The threshold value may be exceeded for a minimum amount of time (a predetermined time) before taking action, which may also be given as a parameter of the function. In general, the basic mode can monitor any physical value. The triggering function can then consider one or more of the monitored physical values when deciding to trigger/not the circuit breaker to take the IED off the grid and avoid damage to the device.

The normal mode may consist of more complex functions such as functions that require as input the history of the monitored physical values (e.g., directional and distance protection functions). Other examples of complex functions are those that depend on other functions. For instance, the inrush protection functions will block the overcurrent function during the switch on of the transformers. In the normal mode, multiple IEDs may be connected and the collected data, i.e. the measured physical values, may be processed for control and/or protection of each of the IEDs.

The method is performed on two entities 11, 12. That is, the method comprises executing the basic mode on a first entity 11 and the normal mode on a second entity 12. The first and second entities 11, 12 may be provided as a single unit, or the first entity 11 may be provided as a separate unit from the second entity 12.

The first entity 11 may be a first processing unit (processor) and the second entity 12 may be a second processing unit (processor). The method may also be performed on a virtual machine, wherein the first entity 11 may be a hypervisor and the second entity 12 may be a virtual machine.

The disclosure also relates to a corresponding IED 1 for power system components. The IED 1 comprises a processing unit 10 configured to execute the method as described above. All functions described in the context of the method are applicable to the IED and vice versa, wherein the processor unit 10 may be configured to execute the respective functions.

Thus, the processing unit 10 is configured to reboot the IED, wherein rebooting comprises reloading an operating system, execute, while the IED 1 is rebooting, a basic mode of the IED 1, wherein the processing unit 10 is configured to provide at least one function for protecting a power system component connected to the IED 1 in the basic mode, and execute a normal mode, after the operating system is reloaded, wherein the processing unit 10 is configured to provide functions for protecting and controlling the power system component in the normal mode.

An exemplary schematic diagram of an IED 1 according to the present disclosure is depicted in Fig. 2. In particular, the IED comprises a processing unit 10 which, in line with the method as explained above, comprises a first entity 11 and a second entity 12. As indicated by the dashed line of the first entity 11, the first and second entities 11, 12 may be provided as a single unit, or the first entity 11 may be provided as a separate unit from the second entity 12. As non-limiting examples, two ways of implementing the processing unit may be described.

As a first example, the processing unit may be a system on chip, SoC, device, wherein the SoC device comprises at least one of a central processing unit, CPU, a digital signal processor, DSP, an image processing unit, or a graphics processing unit, GPU. Multiple elements of a SoC device may be integrated in the same circuit. While the normal mode may utilise the complete SoC device, the basic mode may run on a different processing unit (cf. above) than the normal mode or on a subset of the SoC.

In other words, the normal mode may be executed on a main processing unit (second entity, 12, e.g., the CPU) and the basic mode may run "bare-metal" on a secondary processing unit (first entity 11, e.g., the DSP).

In the event of a system restart, while the main processing unit (second entity 12) is reloading the operating system and the entire software stack, a secondary processing unit (first entity 11) executes "bare-metal" the basic mode. The term "bare-metal" may therein refer to an execution without an operating system. The advantage of bare metal implementation is that it does not require time to load the operating system. Therefore, starting the basic mode may take only a short period of time, e.g. less than one second. During this basic mode, the secondary processing unit may periodically check a flag stored in shared memory. This flag indicates whether the main processing unit restored the entire software stack and is ready to execute in normal mode. Once the system is reloaded, the main unit may set the flag to TRUE, and may resume execution. Optionally, the normal mode (executed on the second entity 12 acting as a main processing unit) takes over the state from the quick-start secondary unit (first entity 11). This state can be available via shared memory. This state memory is also periodically updated by the main processing unit (second entity 12), such that in the event of a system reboot, the quick-start unit (first entity 11) uses this shared state to initialize its functionality.

As a second example, the basic mode may be implemented using a virtual machine. The first entity 11 may be a hypervisor configured to execute the basic mode and the second entity 12 may be a virtual machine configured to execute the normal mode.

A hypervisor, also known as a virtual machine monitor, is the software that creates, runs, and manages virtual machines. In the case of a restart, the hypervisor has an initialization time significantly shorter compared to the entire system load. Therefore, the basic mode logic can run as part of the hypervisor, until the entire virtual machine that provides the normal mode is restored.

When the system restarts, the hypervisor may be very quickly loaded, e.g., in less than one second. The base functionality may be included in the hypervisor and become available, while the virtual machine is being reloaded. Via an internal virtual network, the hypervisor may detect when the virtual machine is restored and hand over the functionality. Subsequently, the normal mode is executed.

The present disclosure also relates to a system comprising a power system component and an intelligent electronic device as described above.

In the present disclosure, a new quick start function for IEDs is provided. By using a basic functionality mode (i.e., basic control and/or protection algorithms) almost immediately after the device restarts and while the operating system is still rebooting, an efficient protection and/or control of a power system component attached to the IED can be ensured. Thereby, damage to the device itself, the power system component and the grid or other devices/elements attached to the IED via the grid may be avoided.

The rest of the functionality (normal mode) becomes available once the entire software stack has been reloaded.

Other aspects, features, and advantages will be apparent from the summary above, as well as from the description that follows, including the figures and the claims.

It is also understood that any reference to an element herein using a designation such as "first," "second," and so forth does not generally limit the quantity or order of those elements. Rather, these designations can be used herein as a convenient means of distinguishing between two or more elements or instances of an element. Thus, a reference to first and second elements does not mean that only two elements can be employed, or that the first element must precede the second element in some manner.

Additionally, a person having ordinary skill in the art would understand that information and signals can be represented using any one of a variety of different technologies and techniques. For example, data, instructions, commands, information, signals, bits and symbols, for example, which may be referenced in the above description can be represented by voltages, currents, electromagnetic waves, magnetic fields or particles, optical fields or particles, or any combination thereof.

A skilled person would further appreciate that any one of the various illustrative logical blocks, units, processors, means, circuits, methods and functions described in connection with the aspects disclosed herein can be implemented by electronic hardware (e.g., a digital implementation, an analog implementation, or a combination of the two), firmware, various forms of program or design code incorporating instructions (which can be referred to herein, for convenience, as "software" or a "software unit"), or any combination of these techniques.

To clearly illustrate this interchangeability of hardware, firmware and software, various illustrative components, blocks, units, circuits, and steps have been described above generally in terms of their functionality. Whether such functionality is implemented as hardware, firmware or software, or a combination of these techniques, depends upon the particular application and design constraints imposed on the overall system. Skilled artisans can implement the described functionality in various ways for each particular application, but such implementation decisions do not cause a departure from the scope of the present disclosure. In accordance with various embodiments, a processor, device, component, circuit, structure, machine, unit, etc. can be configured to perform one or more of the functions described herein. The term "configured to" or "configured for" as used herein with respect to a specified operation or function refers to a processor, device, component, circuit, structure, machine, unit, etc. that is physically constructed, programmed and/or arranged to perform the specified operation or function.

Furthermore, a skilled person would understand that various illustrative logical blocks, units, devices, components and circuits described herein can be implemented within or performed by an integrated circuit (IC) that can include a general purpose processor, a digital signal processor (DSP), an application specific integrated circuit (ASIC), a field programmable gate array (FPGA) or other programmable logic device, or any combination thereof. The logical blocks, units, and circuits can further include antennas and/or transceivers to communicate with various components within the network or within the device. A general purpose processor can be a microprocessor, but in the alternative, the processor can be any conventional processor, controller, or state machine. A processor can also be implemented as a combination of computing devices, e.g., a combination of a DSP and a microprocessor, a plurality of microprocessors, one or more microprocessors in conjunction with a DSP core, or any other suitable configuration to perform the functions described herein. If implemented in software, the functions can be stored as one or more instructions or code on a computer-readable medium. Thus, the steps of a method or algorithm disclosed herein can be implemented as software stored on a computer-readable medium.

In this document, the term "unit" as used herein, refers to software, firmware, hardware, and any combination of these elements for performing the associated functions described herein. Additionally, for purpose of discussion, the various units are described as discrete units; however, as would be apparent to one of ordinary skill in the art, two or more units may be combined to form a single unit that performs the associated functions according embodiments of the present disclosure.

Additionally, memory or other storage, as well as communication components, may be employed in embodiments of the present disclosure. It will be appreciated that, for clarity purposes, the above description has described embodiments of the present disclosure with reference to different functional units and processors. However, it will be apparent that any suitable distribution of functionality between different functional units, processing logic elements or domains may be used without detracting from the present disclosure. For example, functionality illustrated to be performed by separate processing logic elements, or controllers, may be performed by the same processing logic element, or controller. Hence, references to specific functional units are only references to a suitable means for providing the described functionality, rather than indicative of a strict logical or physical structure or organization.

Various modifications to the implementations described in this disclosure will be readily apparent to those skilled in the art, and the general principles defined herein can be applied to other implementations without departing from the scope of the claims. Thus, the disclosure is not intended to be limited to the implementations shown herein, but is to be accorded the widest scope consistent with the novel features and principles disclosed herein, as recited in the claims below.

## Claims

1. Method for controlling an intelligent electronic device, IED (1), for power system components, the method comprising:
rebooting (S2) the IED (1), wherein rebooting comprises reloading an operating system,
executing (S3), while the IED (1) is rebooting, a basic mode of the IED (1), wherein the basic mode comprises monitoring a physical value of a power system component connected to the IED (1) for protecting the power system component, wherein the physical value is at least one of a current, a voltage, a pressure, a temperature, a power, a resistance, or an impedance; and
executing (S1) a normal mode, after the operating system is reloaded, wherein the normal mode comprises functions for protecting and controlling the power system component,
wherein the method is performed on two entities (11, 12) of the IED (1), and
wherein the method comprises executing the basic mode on a first entity (11) and the normal mode on a second entity (12); and
wherein the method further comprises performing a handover procedure, after the operating system is reloaded, to transfer the functions of the basic mode to the normal mode.

2. Method according to claim 1, wherein the execution of the basic mode is stopped after performing the handover procedure.

3. Method according to claim 1 or 2, wherein the power system component is at least one of a circuit breaker, a transformer, a switch/load-break switch, a tap changer, an electric motor, or a capacitor.

4. Method according to any one of claims 1 to 3, wherein the method further comprises triggering a circuit breaker to take the IED (1) off the grid in case the physical value exceeds a predetermined threshold preferably for a predetermined time.

5. Method according to any one of the preceding claims, wherein the first and second entities (11, 12) are provided as a single unit, or wherein the first entity (11) is provided as a separate unit from the second entity (12).

6. Method according to claim 5, wherein the first entity (11) is a first processing unit and the second entity (12) is a second processing unit.

7. Method according to claim 5, wherein the first entity (11) is a hypervisor and the second entity (12) is a virtual machine.

8. Intelligent electronic device, IED (1), for power system components, the IED (1) comprising a processing unit (10, 11, 12) configured to:
reboot the IED (1), wherein rebooting comprises reloading an operating system,
execute, while the IED (1) is rebooting, a basic mode of the IED (1), wherein the processing unit (10, 11, 12) is configured to monitor a physical value of a power system component connected to the IED (1) for protecting the power system component in the basic mode, wherein the physical value is at least one of a current, a voltage, a pressure, a temperature, a power, a resistance, or an impedance; and
execute a normal mode, after the operating system is reloaded, wherein the processing unit (10, 11, 12) is configured to provide functions for protecting and controlling the power system component in the normal mode,
wherein the processing unit (10, 11, 12) comprises two entities (11, 12), and
wherein a first entity (11) is configured to execute the basic mode and a second entity (12) is configured to execute the normal mode; and
wherein the processing unit (10, 11, 12) is further configured to perform a handover procedure, after the operating system is reloaded, to transfer the functions of the basic mode to the normal mode.

9. IED (1) according to claim 8, wherein the processing unit (10, 11, 12) is further configured to stop the execution of the basic mode after performing the handover procedure.

10. IED (1) according to claim 8 or 9, wherein IED (1) is configured to be connected to a power system component, wherein the power system component is at least one of a circuit breaker, a transformer, a switch/load-break switch, a tap changer, an electric motor, or a capacitor.

11. IED (1) according to any one of claims 8 to 10, wherein the processing unit (10, 11, 12) is further configured to trigger a circuit breaker to take the IED (1) off the grid in case the physical value exceeds a predetermined threshold preferably for a predetermined time.

12. IED (1) according to any one of claims 8 to 11, wherein the first and the second entity (12) are provided as a single unit, or wherein the first entity (11) is provided as a separate unit from the second entity (12).

13. IED (1) according to claim 12, wherein the processing unit (10, 11, 12) is a system on chip, SoC, device, wherein the SoC device comprises at least one of a central processing unit, CPU, a digital signal processor, DSP, an image processing unit, or a graphics processing unit, GPU, and
wherein the first entity (11) is configured to execute the basic mode on a subset of the SoC.

14. IED (1) according to claim 12, wherein the first entity (11) is a hypervisor configured to execute the basic mode and the second entity (12) is a virtual machine configured to execute the normal mode.

15. System comprising a power system component and an intelligent electronic device, IED (1), according to any one of claims 8 to 14.

## Patentansprüche

1. Verfahren zur Steuerung einer intelligenten elektronischen Vorrichtung, IED (1), für Stromversorgungssystemkomponenten, wobei das Verfahren Folgendes umfasst:
Neustarten (S2) der IED (1), wobei das Neustarten Neuladen eines Betriebssystems umfasst,
Ausführen (S3) eines Basismodus der IED (1) während des Neustarts der IED (1), wobei der Basismodus Überwachen eines physikalischen Werts einer mit der IED (1) verbundenen Stromversorgungssystemkomponente zum Schützen der Stromversorgungssystemkomponente umfasst, wobei der physikalische Wert mindestens einer von einem Strom, einer Spannung, einem Druck, einer Temperatur, einer Leistung, einem Widerstand oder einer Impedanz ist; und
Ausführen (S1) eines Normalmodus nach dem Neuladen des Betriebssystems, wobei der Normalmodus Funktionen zum Schützen und Steuern der Stromversorgungssystemkomponente umfasst,
wobei das Verfahren auf zwei Entitäten (11, 12) der IED (1) durchgeführt wird, und
wobei das Verfahren Ausführen des Basismodus auf einer ersten Entität (11) und des Normalmodus auf einer zweiten Entität (12) umfasst; und
wobei das Verfahren ferner nach dem Neuladen des Betriebssystems Durchführen einer Übergabeprozedur umfasst, um die Funktionen des Basismodus in den Normalmodus zu übertragen.

2. Verfahren nach Anspruch 1, wobei die Ausführung des Basismodus nach dem Durchführen der Übergabeprozedur gestoppt wird.

3. Verfahren nach Anspruch 1 oder 2, wobei die Stromversorgungssystemkomponente mindestens eines von einem Leistungsschalter, einem Transformator, einem Schalter/Lasttrennschalter, einem Stufenschalter, einem Elektromotor oder einem Kondensator ist.

4. Verfahren nach einem der Ansprüche 1 bis 3, wobei das Verfahren ferner Auslösen eines Leistungsschalters umfasst, um die IED (1) vom Netz zu nehmen, falls der physikalische Wert einen vorbestimmten Schwellenwert, vorzugsweise für eine vorgegebene Zeit, überschreitet.

5. Verfahren nach einem der vorhergehenden Ansprüche, wobei die erste und die zweite Entität (11, 12) als eine einzige Entität vorgesehen sind oder wobei die erste Entität (11) als eine von der zweiten Entität (12) getrennte Entität vorgesehen ist.

6. Verfahren nach Anspruch 5, wobei die erste Entität (11) eine erste Verarbeitungseinheit und die zweite Entität (12) eine zweite Verarbeitungseinheit ist.

7. Verfahren nach Anspruch 5, wobei die erste Entität (11) ein Hypervisor und die zweite Entität (12) eine virtuelle Maschine ist.

8. Intelligente elektronische Vorrichtung, IED (1), für Stromversorgungssystemkomponenten, wobei die IED (1) eine Verarbeitungseinheit (10, 11, 12) umfasst, die zu Folgendem konfiguriert ist:
Neustarten der IED (1), wobei das Neustarten Neuladen eines Betriebssystems umfasst,
Ausführen eines Basismodus der IED (1) während des Neustarts der IED (1), wobei die Verarbeitungseinheit (10, 11, 12) dazu konfiguriert ist, einen physikalischen Wert einer mit der IED (1) verbundenen Stromversorgungssystemkomponente zum Schützen der Stromversorgungssystemkomponente zu überwachen, wobei der physikalische Wert mindestens eines von einem Strom, einer Spannung, einem Druck, einer Temperatur, einer Leistung, einem Widerstand oder einer Impedanz ist; und
Ausführen eines Normalmodus nach dem Neuladen des Betriebssystems, wobei die Verarbeitungseinheit (10, 11, 12) dazu konfiguriert ist, Funktionen zum Schützen und Steuern der Stromversorgungssystemkomponente im Normalmodus bereitzustellen,
wobei die Verarbeitungseinheit (10, 11, 12) zwei Entitäten (11, 12) umfasst und
wobei eine erste Entität (11) dazu konfiguriert ist, den Basismodus auszuführen, und eine zweite Entität (12) dazu konfiguriert ist, den Normalmodus auszuführen; und
wobei die Verarbeitungseinheit (10, 11, 12) ferner dazu konfiguriert ist, nach dem Neuladen des Betriebssystems eine Übergabeprozedur durchzuführen, um die Funktionen des Basismodus in den Normalmodus zu übertragen.

9. IED (1) nach Anspruch 8, wobei die Verarbeitungseinheit (10, 11, 12) ferner dazu konfiguriert ist, die Ausführung des Basismodus nach dem Durchführen der Übergabeprozedur zu stoppen.

10. IED (1) nach Anspruch 8 oder 9, wobei die IED (1) dazu konfiguriert ist, mit einer Stromversorgungssystemkomponente verbunden zu werden, wobei die Stromversorgungssystemkomponente mindestens eines von einem Leistungsschalter, einem Transformator, einem Schalter/Lasttrennschalter, einem Stufenschalter, einem Elektromotor oder einem Kondensator ist.

11. IED (1) nach einem der Ansprüche 8 bis 10, wobei die Verarbeitungseinheit (10, 11, 12) ferner dazu konfiguriert ist, einen Leistungsschalter auszulösen, um die IED (1) vom Netz zu nehmen, falls der physikalische Wert einen vorbestimmten Schwellenwert, vorzugsweise für eine vorgegebene Zeit, überschreitet.

12. IED (1) nach einem der Ansprüche 8 bis 11, wobei die erste und die zweite Entität (12) als eine einzige Entität vorgesehen sind oder wobei die erste Entität (11) als eine von der zweiten Entität (12) getrennte Entität vorgesehen ist.

13. IED (1) nach Anspruch 12, wobei die Verarbeitungseinheit (10, 11, 12) eine Systemchip-Vorrichtung, SoC-Vorrichtung, ist, wobei die SoC-Vorrichtung mindestens eines von einer zentralen Verarbeitungseinheit, CPU, einem digitalen Signalprozessor, DSP, einer Bildverarbeitungseinheit oder einer Grafikverarbeitungseinheit, GPU, umfasst, und wobei die erste Entität (11) dazu konfiguriert ist, den Basismodus auf einer Untergruppe des SoC auszuführen.

14. IED (1) nach Anspruch 12, wobei die erste Entität (11) ein Hypervisor ist, der dazu konfiguriert ist, den Basismodus auszuführen, und die zweite Entität (12) eine virtuelle Maschine ist, die dazu konfiguriert ist, den Normalmodus auszuführen.

15. System, umfassend eine Stromversorgungssystemkomponente und eine intelligente elektronische Vorrichtung, IED (1), nach einem der Ansprüche 8 bis 14.

## Revendications

1. Procédé destiné à contrôler un dispositif électronique intelligent, IED (1), pour composants de système d'alimentation, le procédé comprenant :
le redémarrage (S2) de l'IED (1), le redémarrage comprenant le rechargement d'un système d'exploitation ;
l'exécution (S3), pendant le redémarrage de l'IED (1), d'un mode de base de l'IED (1), le mode de base comprenant la surveillance d'une valeur physique d'un composant de système d'alimentation relié à l'IED (1) en vue de protéger le composant de système d'alimentation, la valeur physique en étant au moins une parmi un courant, une tension, une pression, une température, une puissance, une résistance et une impédance ; et
l'exécution (S1) d'un mode normal, après le rechargement du système d'exploitation, le mode normal comprenant des fonctions de protection et de contrôle du composant de système d'alimentation,
le procédé étant réalisé sur deux entités (11, 12) de l'IED (1), et
le procédé comprenant l'exécution du mode de base sur une première entité (11) et du mode normal sur une deuxième entité (12) ; et
le procédé comprenant en outre la réalisation d'une procédure de commutation, après le rechargement du système d'exploitation, pour transférer les fonctions du mode de base au mode normal.

2. Procédé selon la revendication 1, dans lequel l'exécution du mode de base est interrompue après la réalisation de la procédure de commutation.

3. Procédé selon la revendication 1 ou 2, dans lequel le composant de système d'alimentation en est au moins un parmi un disjoncteur, un transformateur, un interrupteur/interrupteur à coupure en charge, un changeur de prises, un moteur électrique et un condensateur.

4. Procédé selon l'une quelconque des revendications 1 à 3, le procédé comprenant en outre le déclenchement d'un disjoncteur pour retirer l'IED (1) du réseau dans le cas où la valeur physique dépasse un seuil prédéterminé, de préférence pendant un temps prédéterminé.

5. Procédé selon l'une quelconque des revendications précédentes, dans lequel les première et deuxième entités (11, 12) sont fournies sous la forme d'une seule unité, ou dans lequel la première entité (11) est fournie sous la forme d'une unité distincte de la deuxième entité (12).

6. Procédé selon la revendication 5, dans lequel la première entité (11) est une première unité de traitement et la deuxième entité (12) est une deuxième unité de traitement.

7. Procédé selon la revendication 5, dans lequel la première entité (11) est un hyperviseur et la deuxième entité (12) est une machine virtuelle.

8. Dispositif électronique intelligent, IED (1), pour composants de système d'alimentation, l'IED (1) comprenant une unité de traitement (10, 11, 12) conçue pour :
redémarrer l'IED (1), le redémarrage comprend le rechargement d'un système d'exploitation ;
exécuter, pendant le redémarrage de l'IED (1), un mode de base de l'IED (1), l'unité de traitement (10, 11, 12) étant conçue pour surveiller une valeur physique d'un composant de système d'alimentation relié à l' IED (1) pour protéger le composant de système d'alimentation dans le mode de base, la valeur physique en étant au moins une parmi un courant, une tension, une pression, une température, une puissance, une résistance et une impédance ; et
exécuter un mode normal, après le rechargement du système d'exploitation, l'unité de traitement (10, 11, 12) étant conçue pour assurer des fonctions de protection et de contrôle du composant de système d'alimentation dans le mode normal,
dans lequel l'unité de traitement (10, 11, 12) comprend deux entités (11, 12), et
dans lequel une première entité (11) est conçue pour exécuter le mode de base et une deuxième entité (12) est conçue pour exécuter le mode normal ; et
dans lequel l'unité de traitement (10, 11, 12) est en outre conçue pour réaliser une procédure de commutation, après le rechargement du système d'exploitation, afin de transférer les fonctions du mode de base au mode normal.

9. IED (1) selon la revendication 8, dans lequel l'unité de traitement (10, 11, 12) est en outre conçue pour interrompre l'exécution du mode de base après avoir réalisé la procédure de commutation.

10. IED (1) selon la revendication 8 ou 9, l'IED (1) étant conçu pour être relié à un composant de système d'alimentation, le composant de système d'alimentation en étant au moins un parmi un disjoncteur, un transformateur, un interrupteur/interrupteur à coupure en charge, un changeur de prises, un moteur électrique et un condensateur.

11. IED (1) selon l'une quelconque des revendications 8 à 10, dans lequel l'unité de traitement (10, 11, 12) est en outre conçue pour déclencher un disjoncteur afin de retirer l'IED (1) du réseau dans le cas où la valeur physique dépasse un seuil prédéterminé, de préférence pendant un temps prédéterminé.

12. IED (1) selon l'une quelconque des revendications 8 à 11, dans lequel la première et la deuxième entité (12) sont fournies sous la forme d'une seule unité, ou dans lequel la première entité (11) est fournie sous la forme d'une unité distincte de la deuxième entité (12).

13. IED (1) selon la revendication 12, dans lequel l'unité de traitement (10, 11, 12) est un dispositif à système sur puce, SoC, le dispositif SoC comprenant au moins un élément parmi une unité centrale, CPU, un processeur de signal numérique, DSP, une unité de traitement d'images, et une unité de traitement graphique, GPU, et
dans lequel la première entité (11) est conçue pour exécuter le mode de base sur un sous-ensemble du SoC.

14. IED (1) selon la revendication 12, dans lequel la première entité (11) est un hyperviseur conçu pour exécuter le mode de base et la deuxième entité (12) est une machine virtuelle conçue pour exécuter le mode normal.

15. Système comprenant un composant de système d'alimentation et un dispositif électronique intelligent, IED (1), selon l'une quelconque des revendications 8 à 14.
